# EUROPÄISCHE PATENTANMELDUNG

(11) **EP 4 656 386 A1**
(43) Veröffentlichungstag der Anmeldung: **03.12.2025**
(21) Anmeldenummer: 25179211.5
(22) Anmeldetag: 27.05.2025
(51) Int. Cl.: B41F 15/36, B41F 33/00, B41F 15/08, H05K 3/12

(54) **KONTROLLSYSTEM FÜR EINE DRUCKVORRICHTUNG**

(30) Priorität: 27.05.2024 DE 102024114864
(71) Anmelder: Ekra Automatisierungssysteme GmbH, 74357 Bönnigheim (DE)
(72) Erfinder: Vegelahn, Torsten, 75447 Sternenfels (DE); Tepner, Sebastian, 74357 Bönnigheim (DE)
(74) Vertreter: Gleiss Große Schrell und Partner mbB

(57) **Zusammenfassung**

Kontrollsystem (1) für eine Druckvorrichtung (17) zum Bedrucken insbesondere flächiger Substrate, mit einem Gestell (2), an welchem eine Aufnahme (3) für eine Druckvorlage (4), insbesondere Drucksieb oder Druckschablone, angeordnet ist, mit einer Kameraeinrichtung (6), die der Aufnahme (3) zugeordnet ist, und mit einer Benutzerschnittstelle (10) zum Eingeben und/oder Erhalten von Informationen. Es ist eine Auswerteeinrichtung (11) vorgesehen, die mit der Kameraeinrichtung (6) verbunden ist, um zumindest ein von der Kameraeinrichtung (6) erfasstes Bild der Druckvorlage (4) zu empfangen, wobei die Auswerteeinrichtung (11) dazu ausgebildet ist, in Abhängigkeit von dem empfangenen Bild die Druckvorlage (4) als wiederverwendbar oder als nicht-wiederverwendbar zu klassifizieren.

## Beschreibung

Die vorliegende Erfindung betrifft ein Kontrollsystem für eine Druckvorrichtung zum Bedrucken insbesondere flächiger Substrate, mit einem Gestell, an welchem eine Aufnahme für eine Druckvorlage, insbesondere Drucksieb oder Druckschablone, angeordnet ist, mit einer Kameraeinrichtung, die der Aufnahme zugeordnet ist, und mit einer Benutzerschnittstelle zum Eingeben und/oder Erhalten von Informationen.

Weiterhin betrifft die Erfindung ein Drucksystem zum Bedrucken insbesondere flächiger Substrate, mit einem Drucktisch und einer dem Drucktisch zugeordneten Druckvorrichtung, mit einer Aufnahme, die dazu ausgebildet ist, eine Druckvorlage, insbesondere Drucksieb oder Druckschablone, für die Druckvorrichtung zu halten, und mit einer Transportvorrichtung zum Zuführen und Abführen der Druckvorlage.

Ferner betrifft die Erfindung ein Verfahren zum Betreiben des Kontrollsystems sowie ein Verfahren zum Betreiben des Drucksystems.

Kontrollsysteme und Druckvorrichtungen der Eingangsgenannten Art sind aus dem Stand der Technik bereits bekannt. Moderne Drucksysteme arbeiten derart, dass einer Druckvorrichtung mittels einer Zug- und Abführeinrichtung Druckvorlagen in Form von Drucksieben oder Druckschablonen automatisch zugeführt werden, um dann mittels dieser Druckvorlagen einen Druckvorgang auszuführen. Dazu weist die Druckvorrichtung in der Regel eine Aufnahme auf, in welcher die jeweilige Druckvorlage anordenbar und befestigbar ist. Häufig ist die Aufnahme dabei verlagerbar ausgebildet, um eine Ausrichtung der Druckvorlage optimal in Bezug auf das zu bedruckende Substrat, ermöglichen. Dabei weisen moderne Druckvorrichtungen auch ein Kontrollsystem mit einer Kameraeinrichtung auf, die der Aufnahme zugeordnet ist, um die darin befindliche Druckvorlage und insbesondere deren Ausrichtung und Position zu erfassen. Mittels der Kameraeinrichtung, die eine oder mehrere Kameras aufweisen kann, wird außerdem häufig auch das in der Regel unterhalb der Druckvorlage liegende Substrat erfasst, um mittels Bildauswertung die Ausrichtung von Druckvorlage und Substrat zueinander zu ermitteln, um dann in Abhängigkeit von der erfassten Ausrichtung Druckvorlage und Substrat optimal zueinander automatisiert auszurichten. Nach erfolgter Ausrichtung wird ein Druckmedium durch die Druckvorlage, beispielsweise mit einem oder mehreren Rakeln einer Rakeleinrichtung, gedrückt und dadurch auf das Substrat aufgebracht. Danach wird das bedruckte Substrat von der Druckvorlage getrennt und aus der Druckvorrichtung bzw. von dem Drucktisch der Druckvorrichtung entfernt. Weil dieser Vorgang wieder und wieder wiederholt wird, unterliegt auch die Druckvorlage einem Verschleiß und muss ersetzt werden, wenn der Verschleiß ein zulässiges Maß überschritten hat, um Fehldrucke zu vermeiden. Außerdem müssen Druckvorlage und Rakel regelmäßig, häufig mehrmals am Tag, gereinigt werden, um unerwünschte Rückstände, Verunreinigungen oder Beschädigungen zu vermeiden, die das Druckergebnis beeinträchtigen könnten.

Der Erfindung liegt die Aufgabe zugrunde, ein verbessertes Kontrollsystem zu schaffen, das insbesondere den Zustand einer Druckvorlage überwacht.

Die der Erfindung zugrunde liegende Aufgabe wird durch ein Kontrollsystem mit den Merkmalen des Anspruchs 1 gelöst. Dieses hat den Vorteil, dass bereits vorhandene Mittel des Kontrollsystems nunmehr dazu genutzt werden, die Druckvorlage zu überprüfen und dahingehend zu klassifizieren, ob die erfasste Druckvorlage weiter verwendbar ist, oder ob sie beispielsweise einer Reinigung zugeführt werden muss, um sie weiterverwenden zu können, oder ob sie ganz aus dem Produktionsprozess ausgeschlossen werden muss, weil sie derart verunreinigt oder beschädigt ist, dass eine Weiterverwendung der Druckschablone in jedem Fall zu Fehldrucken führen würde. Hierzu sieht das erfindungsgemäße Kontrollsystem vor, dass es die Druckvorlage als wiederverwendbar oder als nicht-wiederverwendbar klassifiziert. Hierzu weist das Kontrollsystem eine Auswerteeinrichtung auf, die mit der Kameraeinrichtung verbunden ist, um zumindest ein von der Kameraeinrichtung erfasstes Bild der Druckvorlage zu empfangen, wobei die Auswerteeinrichtung dazu ausgebildet ist, in Abhängigkeit von dem empfangenen Bild, insbesondere durch Bildauswertung, vorzugsweise KI-unterstützter Bildauswertung, die Druckvorlage als wiederverwendbar oder als nicht wiederverwendbar zu klassifizieren. Die ohnehin vorhandene Kameraeinrichtung wird somit dazu genutzt, zumindest ein Bild der Druckvorlage zu erfassen und der Auswerteeinrichtung zuzuführen. Die Auswerteeinrichtung vollzieht eine Bildauswertung der erfassten Druckvorlage, um beispielsweise den Verschmutzungsgrad der Druckvorlage oder Beschädigungen der Druckvorlage zu erkennen. Wird ein Verschmutzungsgrad erkannt, der einen insbesondere vorgegebenen kritischen Wert überschreitet, wird die Druckvorlage als nicht wiederverwendbar klassifiziert. Dabei bedeutet der Begriff "nicht wiederverwendbar" in diesem Zusammenhang, dass die Druckvorlage zumindest zunächst nicht direkt wiederverwendet werden kann oder soll. Dies schließt nicht aus, dass die Druckvorlage nach einem Reinigungsprozess der Druckvorlage wieder verwendbar ist. Die Klassifizierung betrifft in diesem Fall lediglich die direkte Wiederverwendung der Druckvorlage ohne Zwischenschritte. Wird die Druckvorlage als nicht-wiederverwendbar klassifiziert, so wird sie beispielsweise an eine Reinigungsstation weitergegeben, als nicht-wiederverwendbar markiert und/oder vom weiteren Produktionsprozess insgesamt ausgeschlossen. Dabei erfolgt bevorzugt die Entscheidung zwischen dem Zuführen zu einer Reinigungsanlage und dem vollständigen Ausschließen insbesondere in Abhängigkeit von dem Maß der erfassten Verschmutzung und/oder Beschädigung.

Vorzugsweise weist die Auswerteeinrichtung eine Künstliche Intelligenz und/oder ein neuronales Netzwerk auf, mittels welcher die Bildauswertung des empfangenen Bildes der Druckvorlage durchgeführt wird. Vorzugsweise ist die Auswerteeinrichtung trainiert oder trainierbar mithilfe von Trainingsdatensätzen, die insbesondere vor dem Inbetriebnehmen des Kontrollsystems angefertigt wird, indem Druckvorlagen durch die Kameraeinrichtung erfasst und einem Benutzer angezeigt werden. Dem Benutzer wird vorzugsweise die Möglichkeit gegeben, Stellen der Druckvorlage, die verschmutzt oder beschädigt sind, zu markieren und den Verschmutzungs- oder Beschädigungsgrad anzugeben. Das erfasste Bild wird zusammen mit dem vom Benutzer eingegebenen Daten als Trainingsdatensatz gespeichert und in einem Trainingsprozess dazu verwendet, die KI oder das neuronale Netzwerk derart zu trainieren, dass im späteren Verwendungseinsatz des Kontrollsystems eine automatisierte Klassifizierung, wie sie vorstehend beschrieben wurde, erfolgt.

Vorzugsweise ist die Auswerteeinrichtung mit der Benutzerschnittstelle verbunden, um das Ergebnis der Klassifikation mitzuteilen. So wird der Benutzer nach einer erfolgten Bildauswertung darüber informiert, ob die Druckvorlage als wiederverwendbar oder nicht-wiederverwendbar klassifiziert wurde. Optional werden dem Benutzer außerdem die erkannten Stellen angezeigt, an welchen die Druckvorlage verschmutzt und/der beschädigt ist, sodass der Benutzer gegebenenfalls die automatisch herbeigeführte Klassifizierung manuell Überschreiben und beispielsweise entgegen der Empfehlung des Kontrollsystems die Druckvorlage erneut verwenden bzw. als wiederverwendbar markieren oder als nicht-wiederverwendbar markieren kann.

Vorzugsweise weist die Benutzerschnittstelle dabei Eingabemittel auf, die es dem Benutzer ermöglichen, eine Druckvorlage, deren Bild von der Anzeige angezeigt wird, als wiederverwendbar oder als nicht-wiederverwendbar zu klassifizieren, um einen Trainingsdatensatz zu erstellen. Durch die Eingabe des Benutzers wird somit ein neuer Trainingsdatensatz erstellt, der in dem Kontrollsystem hinterlegt wird. Hierdurch wird das Kontrollsystem auch im laufenden Betrieb weiter trainiert und verbessert, sodass das Kontrollsystem weiter lernt und die Klassifizierung stetig verbessert wird. Vorzugsweise ist das Eingabemittel als Tastatur oder berührungsempfindlicher Bildschirm ausgebildet.

Weiterhin ist bevorzugt vorgesehen, dass die Auswerteeinrichtung zumindest einen nichtflüchtigen Speicher aufweist, in welchem Trainingsdatensätze gespeichert oder speicherbar sind. Somit werden die zuvor beschriebenen Trainingsdatensätze vorteilhaft dauerhaft gespeichert und sind jederzeit für weitere Trainingsdurchläufe verfügbar.

Besonders bevorzugt ist der Aufnahme eine Zu- und Abführeinrichtung zugeordnet, mittels welcher der Aufnahme eine Druckvorlage zuführbar und mittels welcher von der Aufnahme eine Druckvorlage entfernbar ist. Dadurch ist in automatisiertes Zu- und Abführen der Druckvorlagen in das Kontrollsystem bzw. aus dem Kontrollsystem ermöglicht. Dadurch ist eine vollautomatisierte Einbindung des Kontrollsystems in ein Drucksystem in vorteilhafterweise gewährleistet, sodass beispielsweise beim Austausch einer Druckschablone in einer Druckvorrichtung automatisch nach einem erfolgten Druck durch das Kontrollsystem klassifizierbar ist bzw. klassifiziert wird.

Vorzugsweise weist das Kontrollsystem ein Steuergerät auf, das zumindest die Zu- und Abführeinrichtung ansteuert und dazu ausgebildet ist, mit der Auswerteeinrichtung zu kommunizieren. Insbesondere steuert das Steuergerät die Zu- und Abführeinrichtung dazu an, in Abhängigkeit von der Klassifikation der untersuchten Druckvorlage die untersuchte Druckvorlage entweder durch die Abführrichtung zurück zu der Druckvorrichtung, zu einer Reinigungsvorrichtung oder zu einem Abfalllager zu fördern.

Weiterhin ist die Auswerteeinrichtung vorzugsweise dazu ausgebildet, als kritisch qualifizierte Bereiche der Druckschablone derart zu markieren, dass die Markierung zusammen mit der Druckschablone durch die Anzeige dargestellt wird. Hierdurch ist es dem Benutzer in vorteilhafter Weise möglich, wie oben bereits erwähnt, das Ergebnis der Klassifizierung der Auswerteeinrichtung selbst zu prüfen und gegebenenfalls zu ändern.

Das erfindungsgemäße Drucksystem mit den Merkmalen des Anspruchs 11 zeichnet sich durch das erfindungsgemäße Kontrollsystem aus. Es ergeben sich hierdurch die oben bereits genannten Vorteile. Dabei ist das Kontrollsystem bevorzugt derart in das Drucksystem integriert, dass die Aufnahme der Druckvorrichtung die Aufnahme des Kontrollsystems bildet, sodass die Klassifizierung der Druckvorlage in der Druckvorrichtung selbst stattfinden kann und sodass dabei der Raumbedarf für das Kontrollsystem deutlich reduziert wird. Gemäß einer alternativen Ausführungsform ist die Aufnahme des Kontrollsystems separat zu der Aufnahme der Druckvorrichtung ausgebildet, um unabhängig von der Druckvorrichtung die Klassifizierung vornehmen zu können. Dies ergibt den Vorteil, dass während der Durchführung der Klassifizierung die Druckvorrichtung weiterverwendet werden kann.

Weiterhin weist das Drucksystem bevorzugt ein Transportsystem zur Zu- und Abführung der Substrate zu beziehungsweise von dem Drucktisch auf, um ein automatisierten Druckprozess zu gewährleisten. Die vorteilhafte Zu- und Abführvorrichtung für die Druckvorlagen ist je nachdem, ob das Kontrollsystem und die Druckvorrichtung dieselbe Aufnahme oder unterschiedliche Aufnahmen nutzen, als Zu- oder Abführeinrichtung zum Zu- und Abführen der Druckvorlagen in die Druckvorrichtung ausgebildet oder als zusätzliche Zu- und Abführeinrichtung des Kontrollsystems zum Zu- und Abführen der Druckvorlage in die Aufnahme des Kontrollsystems.

Weiterhin bevorzugt weist die Druckvorrichtung eine Rakeleinrichtung auf, mittels welcher Druckmasse durch die Druckvorlage auf das Substrat auf dem Drucktisch aufbringbar ist.

Das erfindungsgemäße Verfahren zum Betreiben des Kontrollsystems mit den Merkmalen des Anspruchs 14 zeichnet sich dadurch aus, dass zumindest ein Bild der Druckvorlage mittels der Kameraeinrichtung erfasst wird, und dass das erfasste Bild durch eine Auswerteeinrichtung als wiederverwendbar oder als nicht-wiederverwendbar in Abhängigkeit von dem erfassten Bild der Druckvorlage klassifiziert wird. Es ergeben sich hierdurch die oben bereits genannten Vorteile. Vorzugsweise wird zur Bildauswertung eine künstliche Intelligenz und/oder ein neuronales Netzwerk eingesetzt, die dazu zuvor mit Trainingsdatensätzen, wie obenstehend beschrieben, trainiert werden. Vorzugsweise werden die künstliche Intelligenz und/oder das neuronale Netzwerk im laufenden Betrieb des Kontrollsystems weiter trainiert, indem dem Benutzer die Möglichkeit gegeben wird, das Ergebnis der Klassifizierung zu überprüfen und bei Bedarf zu überschreiben, wie es obenstehend bereits erläutert wurde.

Das erfindungsmäße Verfahren zum Betreiben des Drucksystems mit den Merkmalen des Anspruchs 15 zeichnet sich durch das erfindungsgemäße Verfahren zum Betreiben des Kontrollsystems aus. Es ergeben sich die oben bereits genannten Vorteile.

Weitere Vorteile und bevorzugte Merkmale und Merkmalskombinationen ergeben sich insbesondere aus dem zuvor Beschriebenen sowie aus den Ansprüchen. Im Folgenden soll die Erfindung anhand der Zeichnung näher erläutert werden. Dazu zeigen:
- **Figur 1**: zeigt ein vorteilhaftes Kontrollsystem und
- **Figur 2**: ein vorteilhaftes Drucksystem, jeweils in einer vereinfachten perspektivischen Darstellung.

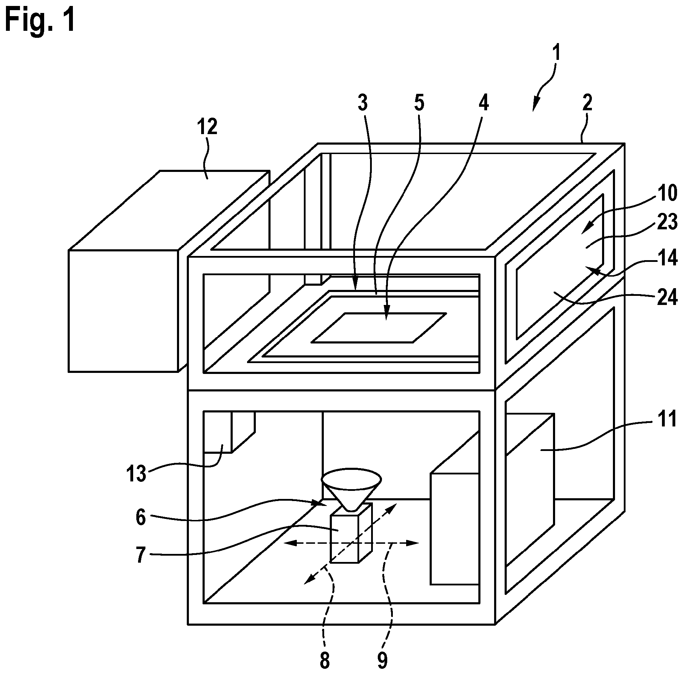

**Figur 1** zeigt in einer vereinfachten perspektivischen Darstellung ein vorteilhaftes Kontrollsystem für Druckschablonen. Das Kontrollsystem 1 weist ein Gestell 2 oder einen Rahmen auf, an welchem eine Aufnahme 3 für Druckschablonen angeordnet ist. Die Aufnahme 3 ist beispielsweise derart ausgebildet, dass die Druckvorlage 4 mit einem Rahmen 5 derart auflegbar ist, dass die Schablonenform frei zugängig ist. Bei der Druckvorlage handelt es sich insbesondere um eine Druckschablone oder ein Drucksieb. Vorliegend ist die Aufnahme 3 insbesondere als Auflage ausgebildet, auf welche die Druckvorlage 4 mit ihrem Außenrand 5 auflegbar ist. Die Aufnahme 3 weist insbesondere eine Öffnung auf, die kleiner ist als der Rahmen 5, sodass die Druckvorlage 4 durch eine Kameraeinrichtung 6, die unterhalb der Aufnahme 3 in oder an dem Gestell 2 angeordnet ist, erfassbar ist. Vorliegend weist die Kameraeinrichtung 6 eine ortsfeste Kamera 7 auf, die der Aufnahme 3 derart zugeordnet ist, dass von der Kamera 7 die gesamt Druckvorlage 4 in einem Bild erfassbar ist. Gemäß einem alternativen Ausführungsbeispiel weist die Kameraeinrichtung 6 mehrere Kameras 7 auf, um die gesamte Druckvorlage in der Aufnahme 3 zu erfassen. Gemäß einem weiteren Ausführungsbeispiel ist vorgesehen, dass die Kameraeinrichtung 6 zwar nur eine Kamera 7 aufweist, diese jedoch, wie in **Figur** 1 durch gestrichelte Pfeile 8 und 9 angezeigt, durch ebenfalls vorhandene Aktuatoren derart bewegbar ist, dass sie durch ihre Bewegung die gesamt Druckvorlage 4 in einem oder mehreren Bildern erfassen kann.

Das Kontrollsystem 1 weist weiterhin eine Benutzerschnittstelle 10 sowie eine Auswerteeinrichtung 11 auf. Die Auswerteeinrichtung 11 ist mit der Kameraeinrichtung 6 sowie mit der Benutzerschnittstelle 10 verbunden und dazu ausgebildet, ein von der Kameraeinrichtung erfasstes Bild der Druckvorlage 4 zu empfangen und in Abhängigkeit von dem empfangenen Bild die Druckvorlage als *"wiederverwendbar"* oder als *"nicht-wiederverwendbar"* zu klassifizieren.

Die Auswerteeinrichtung 11 weist dazu eine künstliche Intelligenz insbesondere ein KI-Modul und/oder ein ein neuronales Netzwerk, mittels welchen eine Bildauswertung des von der Kamera bereitgestellten Bildes der Druckvorlage durchgeführt wird. Dabei wird das Bild darauf untersucht, ob die Druckvorlage Verschmutzungs- oder Verschleißerscheinungen aufweist, die für eine direkte Wiederverwendung der Druckvorlage für einen weiteren Druck nicht geeignet ist. So wird sichergestellt, dass keine beschädigte oder fehlerhafte Druckvorlage in die weitere Produktion zugelassen wird.

Sind mehrere Kameras 7 vorhanden, ist vorzugsweise die Anzahl der Kameras 7 in Abhängigkeit von der Größe der zu untersuchende Druckvorlage und/oder einem gewünschten Durchsatz (Taktzeit) gewählt. Mehrere Kameras verkürzen die Bildaufnahmezeit und vergrößern die laterale Aufnahmefläche. Eine verfahrbare oder bewegbare Kamera verbessert die Interaktion und ermöglicht bei Bedarf, die Kontrolle ausgewählter Bereiche der Druckvorlage. Zu dem kann die eine bewegliche Kamera auch noch zu anderen Zwecken, wie beispielsweise zu einer Ausrichtung von Druckvorlage zu bedruckendem Substrat genutzt werden, wie weiter unten näher erläutert wird.

Die Auswerteinrichtung 11 ist dazu ausgebildet, jedwede Anomalie der Druckvorlage, die den Druckprozess negativ beeinflussen könnte, zu erkennen. Hierzu ist das KI-Modul mit Hilfe von Trainingsdatensätzen dazu trainiert, Abweichungen in der Oberflächenbeschaffenheit, wie beispielsweise Kratzer, Verformungen, beispielweise Dellen oder Beulen, Eingrabungen, Veränderungen der Rauigkeit und Oberflächenbeschichtung, Verschmutzungen der Oberfläche durch Druckpaste oder andere Stoffe, wie auch Verstopfungen der Aperturen oder Öffnungen in der Druckvorlage zu erkennen. Das Training erfolgt vorzugsweise mit unterschiedlichen ausgesuchten Beispielmaterialien in Bezug auf die Druckschablone beziehungsweise die Druckvorlage sowie in Bezug auf die zu verwendende Druckmasse, sodass ein anwendungsfertiges System bereitsteht. Bei jeder Inspektion oder Untersuchungen lernt das KI-Modul hinzu, sodass auf eine aufwändige Betreuung und Parametrisierung des Kontrollsystems verzichtet werden kann.

Vorzugsweise wird dem Kontrollsystem 1 die erwartete Ausbildung der Druckschablone bekannt gemacht, indem beispielsweise zu Beginn des Prozesses die noch unbenutzte Druckschablone ein erstes Mal inspiziert wird, um eine Referenz zu schaffen. Später im Betrieb kann dann das KI-Modul bzw. die Auswerteeinrichtung 11 mit geringem Aufwand Unterschiede zu der Referenz feststellen, und den Grad der Verschmutzung und/oder des Verschleißes der Druckvorlage 4 bestimmen. In Abhängigkeit von dem Grad von Verschmutzung und/oder Verschleiß klassifiziert die Auswerteeinrichtung 11 die Druckvorlage 4 dann als wiederverwendbar oder nicht-wiederverwendbar. Hierbei entscheidet die Auswerteeinrichtung 11 zunächst nur, ob die Druckschablone 4 sofort wieder verwendet werden kann oder nicht. Für den Fall, dass die Druckschablone 4 als *"nicht-wiederverwendbar*" klassifiziert wird, so wird vorzugsweise zusätzlich unterschieden, ob die Druckschablone einem Reinigungsprozess zugeführt werden kann oder soll, um die Druckvorlage 4 wiederverwendbar zu machen, oder ob aufgrund des Verschleiß- oder Verschmutzung ein Reinigungsprozess nicht zu dem erwünschten Ergebnis führen kann, weil die Druckvorlage beispielsweise schwerwiegend beschädigt ist, um dann die nichtwiederverwendbare Druckvorlage zusätzlich als nicht reinigbar oder als Abfall zu klassifizieren, sodass sie dem Produktionsprozess insgesamt entzogen wird.

Insoweit klassifiziert die Auswerteeinrichtung 11 die untersuchte Druckvorlage 4 bevorzugt als *"wiederverwendbar",* als *"nicht-wiederverwendbar aber reinigbar"* oder als *"dauerhaft nicht-wiederverwendbar".*

Optional ist dem Kontrollsystem 1 außerdem eine Ab- und Zuführeinrichtung 12 zugeordnet, mittels welcher die Druckschablonen 4 automatisiert der Aufnahme 3 zugeführt und von dieser entfernt werden können. Beispielsweise ist die Zu- und Abführeinrichtung 12 dazu ausgebildet, die Druckschablonen 4 aus der Aufnahme 13 entnehmen, und sofern diese als wiederverwendbar klassifiziert wurde, einer Druckvorrichtung zur Verwendung zuzuführen, oder, falls die Druckschablone als nicht-wiederverwendbar klassifiziert wurde, die Druckschablone 4 einer Reinigungseinrichtung zuzuführen oder einem Abfall-Lager. Zweckmäßigerweise ist die Zu- und Abführeinrichtung 12 dazu mit der Auswerteeinrichtung 11 und/oder mit einem Steuergerät 13 verbunden, das sowohl die Zu- und Abführeinrichtung 12 als auch die Auswerteeinrichtung 11 und die Benutzerschnittstelle 10 betreibt.

Die Benutzerschnittstelle 10 ist insbesondere als berührungsempfindlicher Bildschirm 14, mit einer Anzeige 23 und einem berührungsempfindlichen Eingabemittel 24 ausgebildet, und dazu eingerichtet, dem Benutzer ein Bild von der gerade untersuchten Druckvorlage 4 anzuzeigen und gegebenenfalls durch die Auswerteeinrichtung 11 aufgefundene Verschmutzungen und/oder Beschädigungen derart zu markieren, dass der Benutzer diese leicht gegenprüfen kann. Stellt der Benutzer fest, dass eine Verschmutzung oder Beschädigung falsch von der Auswerteeinrichtung 11 klassifiziert wurde, kann der Benutzer durch Eingabe an der Benutzerschnittstelle 10 dieses Ergebnis der Auswerteeinrichtung 11 überschreiben und dadurch beispielsweise eine von der Auswerteeinrichtung 11 als nicht-wiederverwendbar klassifizierte Druckschablone als wiederverwendbar klassifizieren und damit das Ergebnis der Auswerteeinrichtung 11 insgesamt zu überschreiben, sodass die Druckvorlage 4 einem weiteren Druckprozess zugeführt werden kann. Vorzugsweise ist die Auswerteeinrichtung 11 dazu ausgebildet, die von dem Benutzer durch die Benutzerschnittstelle 10 getätigten Eingaben zu registrieren und zusammen mit dem Bild der Druckvorlage 4 als Trainingsdatensatz zu speichern, um die Intelligenz beziehungsweise Entscheidungsschärfe der Auswerteeinrichtung 11 weiter zu optimieren.

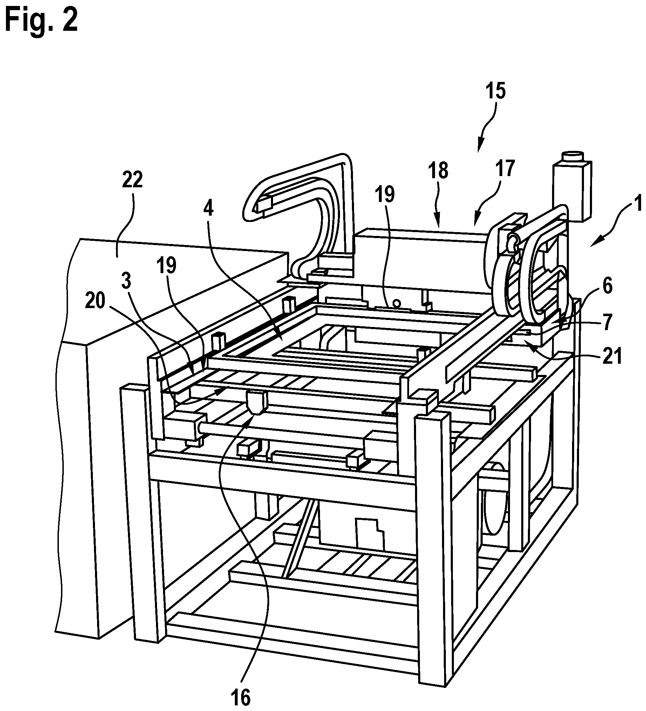

**Figur 2** zeigt in einer vereinfachten perspektivischen Darstellung ein Drucksystem 15 mit einem Drucktisch 16, dem eine Druckvorrichtung 17 zugeordnet ist. Die Druckvorrichtung 17 weist insbesondere eine Rakeleinrichtung 18 auf, mit zumindest einem verlagerbaren Rakel 19. Die Druckvorrichtung 17 weist weiterhin eine Aufnahme 19 für eine Druckvorlage, insbesondere Drucksieb oder Schablone, wie obenstehend beschrieben, auf, die oberhalb des Drucktischs 16 liegt. Weiterhin weist das Drucksystem 15 ein Transportsystem 20 auf, mittels welchem zu bedruckende Substrate, insbesondere flächige Substrate wie Leiterplatten, Wafer oder Platinen, dem Drucktisch 16 zugeführt und von diesem entfernt werden können.

In die Druckvorrichtung 17 ist außerdem das oben beschriebene Kontrollsystem 1 integriert. Dazu bildet die Aufnahme 19 die oben beschriebene Aufnahme 3 des Kontrollsystems 1 aus. Die Druckvorrichtung 17 weist weiterhin eine Kameraeinrichtung 21 auf, die dazu ausgebildet ist, zwischen eine auf der Aufnahme 3 angeordnete Druckvorlage 4 und das zu bedruckende Substrat auf dem Drucktisch 16 bewegt zu werden, um insbesondere mithilfe von Markierungen oder Fudicials (Passermarken) die Ausrichtung von Druckvorlage 4 und Substrat zueinander zu erfassen, um in Folge Drucktisch 16 und/oder einen die Aufnahme 19 beziehungsweise die Druckvorlage 4 und/oder das Substrat derart durch Ansteuerung dafür vorgesehener Aktuatoren zu bewegen, dass die Ausrichtung von Druckvorlage 4 zu Substrat angepasst, insbesondere optimiert wird.

Die Kamera 21 dient in diesem Fall auch als die Kamera 7 der Kameraeinrichtung 6 des Kontrollsystems 1, sodass sie für eine weitere Funktion, nämlich für die Klassifizierung der Druckvorlage 4, die sich auf der Aufnahme 3 befindet, dient.

Somit ist es Kontrollsystem 1 vorteilhaft in die Druckvorrichtung 17 integriert und es wird ein Drucksystem 15 geboten, dass sowohl einen automatischen Druck von Substraten als auch eine automatisierte Kontroll- und Klassifizierung von verwenden Druckvorlagen bietet. Vorzugsweise das Steuergerät als Teil der Druckvorrichtung 17 ausgebildet oder ergänzt eine Steuereinrichtung der Druckvorrichtung 17, um den Gesamtbetrieb des Drucksystems 15 zu steuern.

Optional ist der Druckvorrichtung 15 eine Reinigungsvorrichtung 22 zugeordnet, welcher als *"nicht-wiederverwendbar und reinigbar"* klassifizierte Druckvorlagen 4 durch die Zu- und Abführeinrichtung 12 zugeführt werden, um diese dort zu reinigen und dann wieder zurück in den Positionszyklus einzubringen.

Durch das Kontrollsystem 1 wird erreicht, dass schadhafte oder stark verschlissene und oder verschmutzte Druckvorlagen, die beispielsweise verstopfte Löcher oder beschädigte Konturen aufweisen, nicht erneut für den Druck verwendet und vielmehr automatisiert gereinigt oder aus dem Fertigungsprozess dauerhaft entfernt werden. Dabei lernt das Kontrollsystem 1 durch die vorteilhafte Verwendung der Trainingsdatensätze und das Erstellen weiterer Trainingsdatensätze im laufenden Betrieb dazu und wird somit ständig weiter optimiert.

## Patentansprüche

1. Kontrollsystem (1) für eine Druckvorrichtung (17) zum Bedrucken insbesondere flächiger Substrate, mit einem Gestell (2), an welchem eine Aufnahme (3) für eine Druckvorlage (4), insbesondere Drucksieb oder Druckschablone, angeordnet ist, mit einer Kameraeinrichtung (6), die der Aufnahme (3) zugeordnet ist, und mit einer Benutzerschnittstelle (10) zum Eingeben und/oder Erhalten von Informationen, **gekennzeichnet durch** eine Auswerteeinrichtung (11), die mit der Kameraeinrichtung (6) verbunden ist, um zumindest ein von der Kameraeinrichtung (6) erfasstes Bild der Druckvorlage (4) zu empfangen, wobei die Auswerteeinrichtung (11) dazu ausgebildet ist, in Abhängigkeit von dem empfangenen Bild die Druckvorlage (4) als wiederverwendbar oder als nicht-wiederverwendbar zu klassifizieren.

2. Kontrollsystem nach Anspruch 1, **dadurch gekennzeichnet, dass** die Auswerteeinrichtung (11) eine künstliche Intelligenz und/oder ein neuronales Netzwerk aufweist.

3. Kontrollsystem nach einem der vorhergehenden Ansprüche, **dadurch gekennzeichnet, dass** die Auswerteeinrichtung (11) mit der Benutzerschnittstelle (10) verbunden ist, um das Ergebnis der Klassifikation einem Benutzer mitzuteilen.

4. Kontrollsystem nach einem der vorhergehenden Ansprüche, **dadurch gekennzeichnet, dass** die Benutzerschnittstelle (10) eine Anzeige (23) aufweist, welche dazu ausgebildet ist, das von der Kameraeinrichtung (6) erfasste Bild anzuzeigen.

5. Kontrollsystem nach einem der vorhergehenden Ansprüche, **dadurch gekennzeichnet, dass** die Benutzerschnittstelle (10) Eingabemittel (24) aufweist, die es einem Benutzer ermöglichen, eine Druckvorlage (4), deren Bild von der Anzeige (23) angezeigt wird, als wiederverwendbar oder als nicht-wiederverwendbar zu klassifizieren, um einen Trainingsdatensatz zu erstellen.

6. Kontrollsystem nach einem der vorhergehenden Ansprüche, **dadurch gekennzeichnet, dass** die Auswerteeinrichtung (11) zumindest einen nichtflüchtigen Speicher aufweist, in welchem Trainingsdatensätze gespeichert sind.

7. Kontrollsystem nach einem der vorhergehenden Ansprüche, **dadurch gekennzeichnet, dass** der Aufnahme (3) eine Zu- und Abführeinrichtung (12) zugeordnet ist, mittels welcher der Aufnahme (3) eine Druckvorlage (4) zuführbar und mittels welcher von der Aufnahme (3) eine Druckvorlage (4) entfernbar ist.

8. Kontrollsystem nach einem der vorhergehenden Ansprüche, **dadurch gekennzeichnet, dass** ein Steuergerät (13) vorhanden ist, das zumindest die Zu- und Abführeinrichtung (12) ansteuert und dazu ausgebildet ist, mit der Auswerteeinrichtung (11) zu kommunizieren.

9. Kontrollsystem nach einem der vorhergehenden Ansprüche, **dadurch gekennzeichnet, dass** die Kameraeinrichtung (6) zumindest eine feststehende oder verlagerbare Kamera (7) aufweist.

10. Kontrollsystem nach einem der vorhergehenden Ansprüche, **dadurch gekennzeichnet, dass** die Auswerteeinrichtung (11) dazu ausgebildet ist, als kritisch quailifizierte Bereiche der Druckvorlage (4) derart zu markieren, dass die Markierung zusammen mit dem Bild der Druckvorlage (4) durch die Anzeige (23) dargestellt wird.

11. Drucksystem (15) zum Bedrucken insbesondere flächiger Substrate, mit einem Drucktisch (16) und einer dem Drucktisch (16) zugeordneten Druckvorrichtung (17), mit einer Aufnahme (19,3), die dazu ausgebildet ist, eine Druckvorlage (4), insbesondere Drucksieb oder Druckmaske, für die Druckvorrichtung (17) zu halten, und mit einer Zu- und Abführeinrichtung (12) zum Zu- und Abführen einer Druckvorlage (4), **gekennzeichnet durch** ein Kontrollsystem (1) gemäß einem der Ansprüche 1 bis 10.

12. Drucksystem nach Anspruch 11, **gekennzeichnet durch** ein Transportsystem (20) zur Zu- und Abführung der Substrate.

13. Drucksystem nach einem der Ansprüche 11 oder 12, **dadurch gekennzeichnet, dass** die Druckvorrichtung (17) eine Rakeleinrichtung (18) aufweist.

14. Verfahren zum Betreiben des Kontrollsystems gemäß einem der Ansprüche 1 bis 10, **dadurch gekennzeichnet, dass** zumindest ein Bild der Druckvorlage (4) mittels der Kameraeinrichtung (6) erfasst wird, und dass das erfasste Bild durch eine Auswerteeinrichtung (11) als wiederverwendbar oder als nicht-wiederverwendbar in Abhängigkeit von dem erfassten Bild der Druckvorlage (4) klassifiziert wird.

15. Verfahren zum Betreiben des Drucksystems gemäß einem der Ansprüche 11 bis 13, **dadurch gekennzeichnet, dass** das Kontrollsystem (1) gemäß einem Verfahren nach Anspruch 14 betrieben wird.
